# FASCICULE DE BREVET EUROPEEN

(11) **EP 0 487 361 B1**
(45) Date de publication et mention de la délivrance du brevet: **10.04.1996**
(21) Numéro de dépôt: 91402599.4
(22) Date de dépôt: 30.09.1991
(51) Int. Cl.: C04B 35/00, C04B 35/653, C30B 13/00, C30B 29/22, H01L 39/24

(54) **Méthode de fabrication accélérée de fils ou rubans de céramique supraconducteurs**
Verfahren zur beschleunigten Fabrikation von supraleitenden keramischen Fäden oder Bändern
Accelerated fabrication method for superconducting ceramic fibres or ribbons

(30) Priorité: 21.11.1990 CA 30483
(43) Date de publication de la demande: 27.05.1992
(73) Titulaire: Atomic Energy of Canada Limited L'Energie Atomique du Canada Limitée, Ottawa Ontario, K1A OS4 (CA); HYDRO QUEBEC, Montréal H2Z 1A4, Québec (CA); Alcatel Canada Wire Inc., North York, Ontario M3C 3J4 (CA)
(72) Inventeur: Critchlow, Philip R., St Bruno, PQ (CA); Cave, Julian, Montreal, PQ (CA)
(74) Mandataire: Peuscet, Jacques

(56) Documents cités:
- EP-A- 0 344 812
- WO-A-90/08389
- GB-A- 979 476

## Description

La présente invention a pour objet une méthode pour fabriquer des fils, des rubans ou tout autres éléments allongés du même genre, faits en céramique supraconductrice à température de transition élevée, laquelle méthode est beaucoup plus rapide et efficace que les méthodes connues actuellement.

Dans la description qui va suivre, l'expression"un élément de longueur donné" signifie un fil, un ruban, une barre, un anneau, un cylindre ou tout autre élément analogue de forme allongée, fait en céramique supraconductrice.

De façon analogue, l'expression "céramique supraconductrice à température de transition élevée" signifie tout matériau fait de céramique supraconductrice comme, par exemple, en oxyde d'yttrium, de baryum et de cuivre (Y Ba₂Cu₃O_{7-δ} ou en oxydes de Bi, Sr, Ca et Cu ou de Tl, Sr, Ca et Cu, lequel matériau a une température de transition Tc élevé, l'adjectif "élevé" signifiant ici supérieur au point d'ébullition de l'azote liquide (77 K).

On attribue actuellement de nombreuses applications possibles dans le futur aux céramiques supraconductrices à température de transition élevée notamment dans le domaine des équipements électriques utilitaires à haute densité de courant et faible champ.

De façon à rendre ces céramiques utilisables dans des applications pratiques, il est nécessaire de les fabriquer sous forme de fils, rubans, barres, anneaux ou cylindres.

Une telle fabrication s'est avérée jusqu'à présent complexe et difficile compte tenu de la nature céramique de ces matériaux qui, d'une part, ont une structure granulaire à même après frittage et qui, d'autre part, contiennent toujours des phases secondaires, des impuretés non désirées ou des pores, qui ensemble contribuent à limiter la valeur de leur densité de courant critique.

Récemment, des méthodes ont été développées pour tenter de résoudre ces problèmes de fabrication. Une de ces méthodes qui s'est avérée jusqu'à présent être la plus efficace consiste à procéder à une solidification directionnelle d'un fil, d'un ruban ou d'une barre fait en matériau précurseur de céramique supraconductrice, en utilisant une technique connue sous le nom de "solidification directionnelle par zone fondue" (zone melting) utilisée dans le domaine de la métallurgie pour purifier les métaux.

Cette technique, appliquée aux céramiques supraconductrices, permet d'obtenir :
1- une orientation microcrostructurelle des grains de céramique du fait de la solidification directionnelle; et
2- une pureté élevée sur la presque totalité de l'élément céramique obtenu compte tenu de la tendance "naturelle" des impuretés à s'accumuler dans la phase liquide de la zone fondue et, de là, à se concentrer dans cette zone au fur et à mesure que celle-ci se déplace le long du fil, du ruban ou de la barre.

Cette méthode de solidification directionnelle (melt-texturing) et son application dans la fabrication de fil de céramique supraconductrice de quelques centimètres de long, sont décrits, à titre d'exemple, par R. L. MENG et coll. dans la revue Nature, 345, pages 326 à 328 (1990) et par P.J. Mc GINN et coll. dans la revue Physic, C-161, pages 198 à 203 (1989) et Physic, C-165, pages 480 à 484 (1989).

En pratique, cette méthode connue comprend les quatre étapes de base suivantes:
1- formation d'un fil, ruban ou barre fait de grains de précurseur de céramique;
2- frittage de ces grains;
3- solidification directionnelle de l'élément fritté ainsi obtenu en passant le fil, le ruban ou la barre dans un four tubulaire ayant une zone chaude dont la température est au dessus de la température de décomposition péritectique du précurseur de céramique; et
4- recuit à l'oxygène de l'élément céramique de microstructure orientée obtenu à l'étape 3 directionnelle dans un autre four, de façon à ajuster sa teneur en oxygène de valeur prédéterminée connue pour augmenter sa température de transition.

Tel qu'indiqué ci-dessus, cette méthode connue s'est avérée être efficace au moins en laboratoire, pour fabriquer de façon continue ou semi continue de courts fils de céramique supraconductrice, en particulier en YBa₂Cu₃O_{7-δ} ,capables de transporter de forts courants du fait que, d'une part, ces éléments ont des grains alignés et ont une bonne connection intragranulaire grâce à l'orientation microstructurelle obtenue lors de la solidification directionnelle et, du fait que, d'autre part, qu'ils possèdent une concentration réduite d'impuretés sur pratiquement leur longueur compte tenu de l'accumulation de ces impuretés dans la zone fondue au fur et à mesure que celle-ci passe par rapport au fil lorsque ce fil se déplace dans le four tubulaire, les impuretés se trouvant donc accumulées tout à fait à l'extrémité arrière du fil une fois celui-ci passé dans le four, cette extrémité pouvant être ultérieurement coupée.

En dépit de cette efficacité reconnue, la méthode de solidification directionnelle ci-dessus décrite a deux limitations majeures qui ont empêché jusqu'à présent sa généralisation.

La première de ces limitations est la lenteur de cette technique où une vitesse de production de quelques millimètres par heure seulement ne peut être dépassé si l'on veut obtenir une solidification directionnelle adéquate. Cette première limitation a été reconnue par R.L. MENG et coll. qui, à la fin de leur article ci-dessus mentionné, suggèrent de varier les paramètres procéduraux ou le diagramme de phase de la céramique au moyen de dopant pour augmenter la vitesse de croissance des grains.

L'autre limitation majeure est le fait que les impuretés qui ont tendance à s'accumuler dans la zone fondue au fur et à mesure que le traitement progresse et, par conséquent, ont tendance à s'accumuler le long de l'élément superconducteur au fur et à mesure que celui-ci est formé, jusqu'à ce que les propriétés électriques et/ou mécaniques de cet élément soient finalement détruits. Cette seconde limitation réduit à quelques centimètres la longueur des fils qui peuvent être fabriqués selon cette méthode.

La demande de brevet européen publiée EP-A-0.344.812 décrit en pages 10 et 11 une méthode de fabrication d'un élément en céramique supraconductrice, selon laquelle une pluralité de sources de chaleur qui définissent un nombre identique de zones de chauffage se déplacent ensemble le long d'un élément précurseur. Ces sources de chaleur passent chacune sur toute la longueur de l'élément précurseur de façon à former l'élément en céramique supraconductrice désiré. L'utilisation d'une pluralité de sources de chaleur n'est pas destinée à réduire le temps nécessaire pour traiter toute la longueur de l'élément, mais plutôt à augmenter le degré d'orientation microstructurelle des grains de précurseur et, de là, augmenter la densité de courant. En plus, cette méthode ne propose aucune solution à l'autre limitation ci-dessus évoquée.

L'objet de la présente invention est une nouvelle méthode de fabrication de n'importe quel élément de longueur donnée, fait en céramique supraconductrice à une température de transition élevée, laquelle méthode dérive de la méthode de solidification directionnelle ci-dessus mentionnée mais sans avoir pour autant en avoir les limitations connues.

L'objet de la présente invention est donc de fournir une méthode de fabrication du même type que précédemment, mais qui est suffisamment améliorée pour ne pas en avoir les limitations.

La méthode selon l'invention comprend sensiblement les mêmes étapes de base que la méthode de solidification directionnelle ci-dessus mentionnée, si ce n'est la seconde de ces étapes de base, à savoir l'étape de frittage qui, s'est avérée en pratique ne pas être essentielle pour obtenir de bons résultats et qui, peut donc être omise bien qu'on puisse la conserver si désiré.

La méthode selon l'invention comprend donc les étapes de base suivantes:
- formation d'un élément de longueur donnée à partir d'un précurseur de céramique supraconductrice à température de transition élevée, les grains de précurseurs étant disposés de façon à s'étendre les uns à côté des autres sur toute la longueur de l'élément;
- solidification directionnelle par zone fondue de l'élément sur toute la longueur de celui-ci à des température et vitesse suffisantes pour modifier l'orientation microstructurelle des grains de précurseur et ainsi obtenir de nouveaux grains qui sont alignés et ont une bonne connexion intragranulaire; et
- recuit sous oxygène de l'élément en céramique supraconductrice ainsi obtenu par solidification directionnelle de façon à ajuster sa teneur en oxygène et augmenter sa température de transition.

La méthode selon l'invention se distingue des technique antérieures en ce que:
- on utilise plusieurs sources de chaleur chauffant à une même température de fusion un nombre correspondant d'endroits différents également espacés sur au moins une partie de la longueur dudit élément;
- on déplace l'élément et les sources de chaleur l'un par rapport à l'autre de façon à ce que chacun desdits endroits sur ladite longueur de l'élément soit sujet à un seul et unique passage sous une desdites sources de chaleur, ce passage assurant la solidification directionnelle requise simultanément auxdits endroits différents de ladite longueur, et ce à un même moment, à une même température, à une même vitesse et dans une même direction de façon à former un nombre identique de zones analogues de microstructure orientée le long de ladite partie traitée de l'élément, lesdites zones croissant en longueur jusqu'à ce qu'elles se rejoignent.

Bien entendu, toute autre partie non encore traitée de la longueur dudit élément doit subir le même traitement jusqu'à toute la longueur donnée soit formée de zones de microstructure orientée jointes les unes aux autres.

En outre, avant de procéder à cette solidification directionnelle, la distance entre les différents endroits où cette solidification directionnelle simultanément est effectuée, est ajustée en fonction de la quantité d'impuretés initialement présentes dans le précurseur pour s'assurer que la concentration d'impuretés qui a tendance à augmenter le long des zones de microstructure orientée au fur et à mesure que ces zones sont formées le long de l'élément, demeure toujours en dessous d'une valeur prédéterminée ou la supraconductivité requise de l'élément ainsi fabriqué n'est pas réduite de façon indue.

Comme on peut maintenant le comprendre, la méthode selon l'invention permet de multiplier la vitesse actuelle de fabrication connue pour être très lente par un coefficient du même ordre de grandeur que le nombre de différents endroits où une solidification directionnelle simultanée est effectuée. Si ce nombre d'endroits est, par exemple, égal à 10, la vitesse de production se trouvera alors multipliée par un coefficient du même ordre de grandeur que ce nombre, soit 10.

Comme on peut également le comprendre, une détermination adéquate de la quantité d'impuretés présentes dans le précurseur utilisé comme matériau de départ permettra de déterminer de façon appropriée la distance devant séparer les différents endroits où une solidification directionnelle simultanée sera effectuée, étant entendu que cette distance doit satisfaire à deux exigences opposées. En effet, il est d'une part nécessaire que cette distance soit suffisamment petite pour éviter que trop d'impuretés ne s'accumulent dans les extrémités des diverses zones de microstructure orientée se formant au cours de la méthode. Par contre, plus cette distance est grande, plus la qualité du produit obtenu sera également grande puisqu'un léger chevauchement entre les zones de microstructure orientée adjacentes est absolument nécessaire mais doit être limité au plus petit nombre possible pour ne pas nuire aux propriétés du conducteur.

L'invention et ses divers avantages ressortiront mieux de la description plus générale à suivre, faite en se référant aux dessins annexés dans lesquels:
la fig. 1a est une représentation schématique d'un fil fait en un précurseur de supraconducteur, lequel fil est soumis à un traitement de solidification directionnelle multiple selon l'invention, juste après que ce traitement ait commencé;
les figs 1b et 1c sont des représentations schématiques similaires à celle de la fig. 1a, montrant le même fil au fur et à mesure que le traitement progresse et à la fin de celui-ci, respectivement;
la fig. 1d est une courbe montrant le pourcentage des impuretés le long du fil, à la fin du traitement; déplaçant le long d'un chemin prédéterminé, montrée ici comme ayant la forme d'une spirale, où il subit un traitement, de solidification directionnelle multiple selon l'invention;
la fig. 3 est une vue en perspective du fil illustré sur la fig. 2, montrant un seul alignement de source de chaleur; et
la fig. 4 est une vue similaire à celle de la fig. 2, montrant une autre façon de soumettre le même fil se déplaçant le long d'une spirale à un traitement de solidification directionnelle multiple selon l'invention.

Tel que précédemment indiqué, la méthode selon l'invention comprend trois étapes de base dont deux, à savoir la première et la dernière, sont très conventionnelles.

La première étape de la méthode selon l'invention consiste à former un élément de longueur donnée, fait de grains d'un précurseur de céramique supraconductrice à température de transition élevée. Les précurseurs de céramiques supraconductrices sont des matériaux connus en tant que tels. Aucune description n'en sera donc donnée. De même, la façon d'arranger les grains précurseurs de façon à ce qu'ils s'étendent les uns à côté des autres sur toute la longueur de l'élément est une technique bien connue des spécialistes dans ce domaine très particulier.

En pratique, la formation de l'élément peut être effectué en insérant et empilant les grains de précurseur dans un tube creux fait en un métal tel que l'argent, ou un alliage métallique tel que un alliage Ag-Pd, qui est connu pour être perméable à l'oxygène, de façon à permettre l'étape ultérieure de recuit sous oxygène de la céramique après traitement. Le tube ainsi rempli peut être tréfilé pour obtenir le fil ou ruban désiré.

Selon une autre méthode, l'élément peut être formé en appliquant les grains de précurseurs sur un support par pulvérisation par plasma (plasma spraying) ou par tartinage (Doctor blading).

Bien qu'il ait été déterminé que cela ne soit pas réellement nécessaire, l'élément formé tel que décrit ci-dessus peut être soumis à un traitement thermique dont les conditions opératoires sont bien connues, pour obtenir un frittage des grains de précurseur avant de soumettre l'élément à l'étape suivante de solidification directionnelle. Ce traitement de frittage facultatif peut accélérer l'ensemble des procédures.

La deuxième étape de la méthode selon l'invention consiste à faire subir à l'élément précédemment formé et le cas échéant fritté une solidification directionnelle par zone fondue sur toute sa longueur à des température et vitesse suffisantes pour modifier l'orientation microstructurelle des grains de précurseur et ainsi obtenir de nouveaux grains qui sont alignés et ont une bonne connexion intragranulaire.

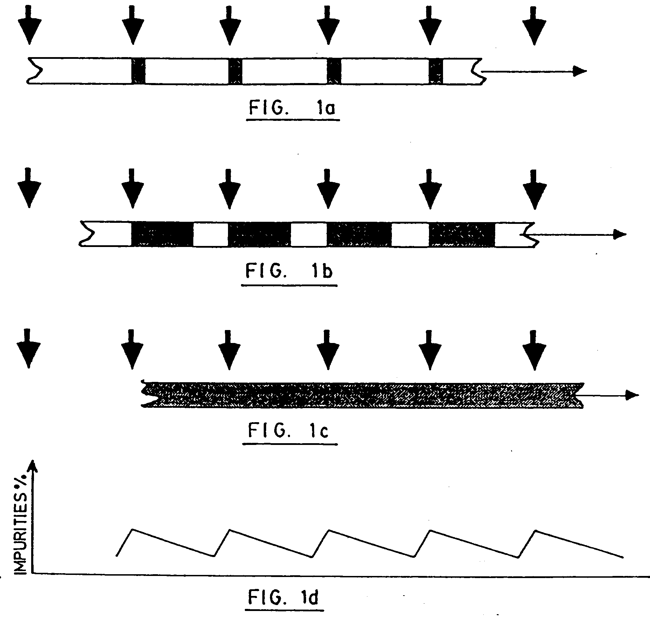

Selon l'invention, cette solidification directionnelle est effectuée simultanément à un nombre d'endroits différents illustrés à l'aide de flèches sur les figs 1a à 1c, 2 et 3, ces endroits étant également espacés sur au moins une partie de la longueur de l'élément subissant le traitement.

Plus particulièrement, cette solidifcation directionnelle multiple est effectuée à ces endroits différents au même moment, à la même température, à la même vitesse et dans la même direction de façon à former un ensemble identique de zones analogues de microstructure orientée illustrées en gris sur les figs 1a à 1c, lesquelles s'étendent le long de la partie traitée de l'élément et croissent en longueur au fur et à mesure que le traitement avance jusqu'à ce qu'elles se rejoignent (voir fig. 1c).

Pour effectuer cette solidification directionnelle multiple de l'élément, on peut utiliser plusieurs sources de chaleur espacées de façon égale, qui peuvent être constituées de lampes infrarouges, de bobines d'induction, de laser, d'impulsions de courant longitudinal ou transversal, etc. Chaque source de chaleur fait subir une solidification directionnelle à une longueur prédéterminée du conducteur (voir fig. 1a qui montre l'élément juste après que le traitement ait commencé, avec la zone de microstructure orientée illustrée en gris). Au fur et à mesure que l'élément supraconducteur se déplace lentement vers l'avant, préférablement sous contrôle d'un ordinateur, ces zones de microstructures orientées deviennent de plus en plus longues (voir fig. 1b) jusqu'à ce qu'elles se rejoignent (voir fig. 1c).

Ainsi, la vitesse moyenne de production se trouve multipliée par un coefficient sensiblement identique au nombre de sources de chaleur.

Selon une autre caractéristique très importante de l'invention, la distance entre les sources de chaleur doit être déterminée en fonction de la quantité d'impuretés présentes initialement dans l'élément, et de la tolérance de l'élément de céramique conductrice obtenu à la présence d'une éventuelle accumulation de telles impuretés. Plus la distance est grande, mieux c'est puisqu'un léger chevauchement des zones de microstructure orientée est absolument nécessaire et qu'un tel chevauchement affecte les propriétés supraconductrices ou mécaniques de l'élément.

Toutefois, puisque la concentration d'impuretés tend à augmenter le long des zones de microstructure orientée au fur et à mesure que ces zones sont formées le long de l'élément (voir fig. 1d) compte tenu du fait que les impuretés ont tendance à se concentrer naturellement dans la phase liquide de la zone fondue, il est également nécessaire que cette distance ne soit pas trop large pour éviter que la concentration d'impuretés n'atteigne une valeur critique où les propriétés supraconductrices de l'élément sont "détruites".

En conséquence, ces deux exigences contradictoires quant à la distance qui doit séparer les sources de chaleur doivent faire l'objet d'un compromis avant d'amorcer le traitement. Ceci est effectué en déterminant la quantité d'impuretés présentes dans le précurseur, en déterminant la concentration maximum d'impuretés qui peut être considérée comme "acceptable" dans le produit fini et en ajustant la distance entre les sources de chaleur (à savoir la distance entre les flèches sur les figures) de façon à s'assurer que la concentration d'impuretés à la fin de chaque zona de microstructures orientées une fois que le traitement est achevé soit en dessous de la valeur maximum prédéterminée.

De préférence, le traitement de solidification directionnelle multiple est effectué en déplaçant l'élément le long du nombre donné de sources de chaleur identiques espacées les unes des autres telles que précédemment décrites, les sources étant dans ce cas immobiles. Selon un autre mode possible de réalisation, l'élément pourrait toutefois demeurer fixe et les sources de chaleur déplacer ensemble le long de celui-ci.

Le gradient de température qui doit être généré par les sources de chaleur dans l'élément pour obtenir une solidification directionnelle efficace dépend bien entendu du type de céramique utilisé pour la fabrication de l'élément. Ce gradient dépend aussi de la température des sources de chaleur et de la vitesse à laquelle l'élément se déplace par rapport à celles-ci.

En assumant par exemple que le précurseur consiste en une fine poudre d'un précurseur de YBa₂Cu₃O_{7-δ}, la solidification directionnelle multiple peut être effectuée à une température comprise entre 1000 et 1100°C à une vitesse ajustée de façon à avoir un gradient de température comprise entre 20 et 200°C/mm dans l'élément, de façon à ainsi s'assurer que toutes les impuretés soient entièrement dissoutes et soient déplacées dans la phase liquide de la zone fondue au fur et à mesure que les zones de microstructures orientées sont formées.

D'autres exemples de conditions d'opération utilisables avec d'autres types de céramique sont donnés dans le tableau ci-dessous.

| | céramique à base d'ytrium | céramique à base de bismuth | céramique à base de thallium |
|---|---|---|---|
| gradient de température (°C/mm) | 20-200 | 20-200 | 20-200 |
| temp. (°C) | 1000-1100 | 850-900 | 800-1200 |
| temps dans la zone fondue (mins) | 1-15 | 1-15 | 1-15 |
| température de frittage (°C) si désiré | 925-975 | 800-900 | 800-900 |

Le traitement de solidification directionnelle multiple selon l'invention peut être effectué à l'air ou sous atmosphère inerte, sur toute la longueur de l'élément ou sur une partie seulement de celui-ci, si cet élément est très long et le nombre de sources de chaleur est réduit. Dans ce dernier cas, l'élément devra bien entendu être déplacé rapidement vers l'avant après qu'une partie de sa longueur ait subi le traitement de solidification directionnelle multiple, de façon à amener rapidement la partie suivante de sa longueur non encore traitée immédiatement en position par rapport aux sources de sa chaleur avant de recommencer le traitement et ainsi de suite jusqu'à ce que l'ensemble de l'élément soit traité.

Une fois encore, cette suite d'étapes peut être aisément contrôlé par un ordinateur. Dans ce cas, dès qu'une section donnée de la longueur de l'élément supraconducteur aura subi le traitement de solidification directionnelle, l'ordinateur procédera automatiquement, avec précision et rapidement procédera à l'avancement de l'élément de façon-à ce que la section suivante non encore traitée soit amengte le plus rapidement en position avant de redémarrer le traitement de solidification directionnelle multiple.

Quand toutes les parties de la longueur de l'élément a aussi été traité par le même type de solidification directionnelle multiple et que toute la longueur dudit élément est composée de zones de microstructures orientées jointes, l'élément peut alors être soumis à la troisième et dernière étape de la méthode selon l'invention.

Cette troisième étape bien connue dans ce domaine consiste à procéder à un recuit sous oxygène de l'élément de céramique supraconductrice obtenue après solidification directionnelle de façon à ajuster sa teneur en oxygène et augmenter sa température de transition. Un tel recuit à l'oxygène peut être effectué dans un four séparé à une température de, par exemple, 450°C.

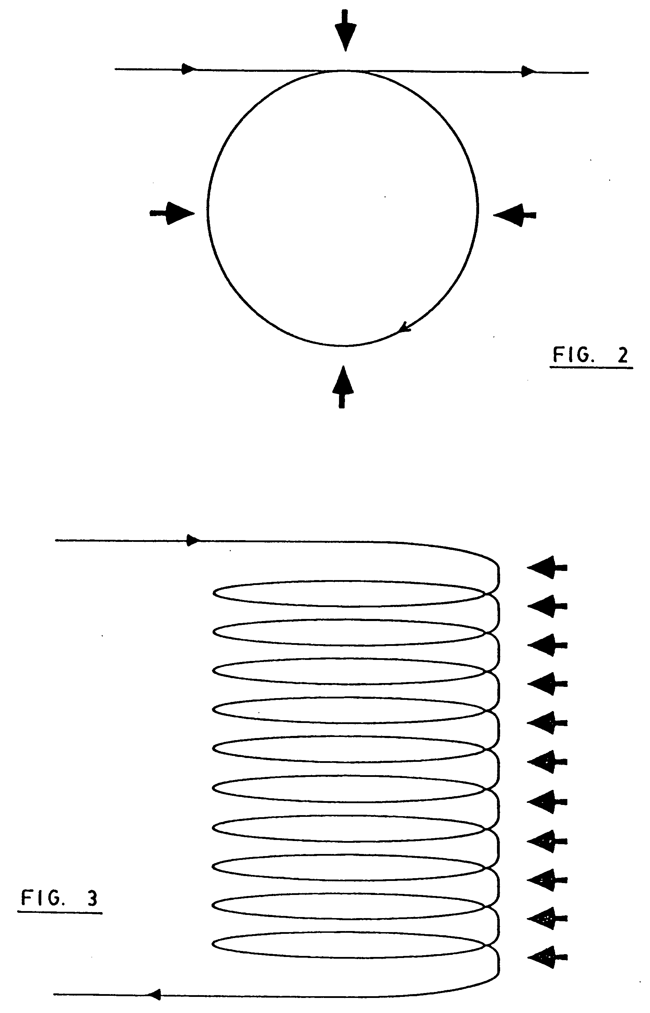

Les figs 2 à 4 montrent une façon pratique de mettre en oeuvre la seconde étape de la méthode selon l'invention de façon à augmenter encore plus la vitesse de production.

Dans ce mode de réalisation, l'élément est déplacé le long d'une spire, pour ainsi former un enroulement de plusieurs spirales. Les sources de chaleur (montrées là encore avec des flèches) sont alors positionnées le long d'au moins un mais de préférence plusieurs lignes interceptant les spires.

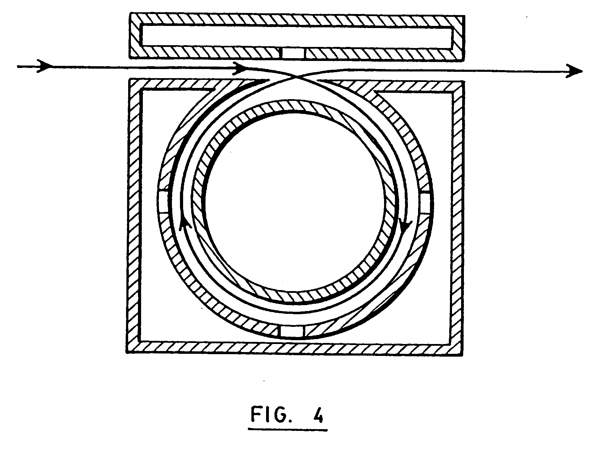

Plutôt que d'utiliser des sources de chaleur séparées ou des alignements de telles sources, l'élément peut être déplacé dans un écran de protection thermique qui a la forme d'une spirale et est placée dans un four chauffé à la température requise pour obtenir la solidification directionnelle. Dans ce cas, les sources de chaleur sont constituées par de simples trous qui prévus dans l'écran de protection thermique le long de celui-ci à l'intérieur du four, tel qu'illustré sur la fig. 4.

Dans tous les cas, l'élément de céramique supraconductrice est traité sous la forme d'un enroulement de plusieurs spires, où les sources de chaleur peuvent être alignées ou arrangées de façon à en tirer un maximum d'avantages. En utilisant des spires de large diamètre, comme par exemple de l'ordre de 3 m, et un nombre important,de spires comme, par exemple, de 20 à 200, la vitesse de fabrication peut ainsi être augmentée par un facteur de 10³ à 10⁴ ou plus.

Bien entendu, le contrôle de la température de l'environnement à l'intérieur du four peut également être envisagé.

## Revendications

1. Méthode de fabrication d'un élément de longueur donnée fait en céramique supraconductrice à température de transition élevée, du type comprenant les étapes suivantes:
- formation de l'élément de longueur donnée à partir de grains de précurseur de ladite céramique supraconductrice à température de transition élevée, ces grains s'étendant les uns à côté des autres sur toute la longueur dudit élément ;
- solidification directionnelle par zone fondue dudit élément sur toute sa longueur à des température et vitesse suffisantes pour modifier l'orientation microstructurelle des grains de précurseur et ainsi obtenir de nouveaux grains qui sont alignés et ont une bonne connexion intragranulaire; et
- recuit sous oxygène de l'élément en céramique supraconductrice ainsi obtenu après solidification directionnelle de façon à ajuster sa teneur en oxygène et augmenter sa température de transition;
ladite méthode étant caractérisée en ce que:
- on utilise plusieurs sources de chaleur chauffant à une même température de fusion un nombre correspondant d'endroits différents également espacés sur au moins une partie de la longueur dudit élément;
- on déplace l'élément et les sources de chaleur l'un par rapport à l'autre de façon à ce que chacun desdits endroits sur ladite longueur de l'élément ne soit sujet à un seul et unique passage sous une desdites sources de chaleur, ce passage assurant la solidification directionnelle requise simultanément auxdits endroits différents de ladite longueur, et ce à un même moment, à une même température, à une même vitesse et dans une même direction de façon à former un nombre identique de zones analogues de microstructure orientée le long de ladite partie traitée de l'élément, lesdites zones croissant en longueur jusqu'à ce qu'elles se rejoignent;
- l'on fait subir le même traitement à toute autre partie non encore traitée de la longueur dudit élément jusqu'à ce que toute cette longueur soit formée de zones de microstructure orientée jointes les unes aux autres; et
- avant de procéder à cette solidification directionnelle, la distance entre les différents endroits où ladite solidification directionnelle simultanée est effectuée, est ajustée en fonction de la quantité d'impuretés initialement présentes dans le précurseur pour s'assurer que la concentration d'impuretés qui a tendance à augmenter le long des zones de microstructure orientée au fur et à mesure que ces zones sont formées le long de l'élément, demeure toujours en dessous d'une valeur prédéterminée où la supraconductivité requise de l'élément ainsi fabriqué n'est pas réduite de façon indue.

2. Méthode selon la revendication 1, caractérisée en ce que la solidification directionnelle est effectuée en déplaçant l'élément le long desdites sources de chaleur.

3. Méthode selon la revendication 2, caractérisée en ce que l'élément se déplace le long d'une spirale et forme ainsi un enroulement de plusieurs spires, et en ce que les sources de chaleur sont positionnées le long d'au moins une ligne interceptant lesdites spires.

4. Méthode de la revendication 3, caractérisée en ce que la spirale se trouve dans un four chauffé à la température requise pour assurer la solidification directionnelle désirée, et en ce que les sources de chaleur sont constituées par des trous prévus dans un écran thermique servant à protéger l'élément se déplaçant le long de la spirale à l'intérieur du four.

5. Méthode selon l'une quelconque des revendications 1 à 4, caractérisée en ce que l'élément est formé en insérant les grains de précurseur dans un tube creux fait d'un alliage métallique perméable à l'oxygène, puis en procédant à un tréfilage dudit tube en un fil ou ruban.

6. Méthode selon l'une quelconque des revendications 1 à 4, est caractérisée en ce que l'élément est formé en appliquant les grains de précurseur sur un support par pulvérisation par plasma, ou par tartinage.

7. Méthode selon l'une quelconque des revendications 1 à 6, caractérisée en ce qu'elle comprend en outre un frittage des grains de précurseur avant de soumettre l'élément à ladite solidification directionnelle.

8. Méthode selon l'une quelconque des revendications 1 à 7, caractérisée en ce que:
- le précurseur consiste en une poudre de précurseur de Y Ba₂Cu₃O_{7-δ}; et
- la solidification directionnel est effectuée à une température comprise entre 1000 et 1100°C et est ajustée de façon à avoir un gradient de température compris entre 20 et 200°C par millimètre dans l'élément pour ainsi s'assurer que toutes les impuretés soient bien dissoutes et déplacées le long des zones de microstructure orientée au fur et à mesure que celles-ci se forment et croissent en longueur.

## Claims

1. A method for producing a high transition temperature superconducting ceramic element of a given length, of the type comprising the following steps:
- formation of the element of given length with grains of a high transition temperature superconducting ceramic precursor material, said grains extending adjacent each other over all the length of said element;
- melt texturing by zone melting said element over all its length at a temperature and a speed sufficient to modify the microstructural orientation of the grains of precursor material and thus to obtain new grains that are aligned and have a good intergranular connection; and
- oxygen annealing of the so-obtained melt-textured supraconducting ceramic element in order to adjust its oxygen level and raise its transition temperature,
said method being characterized in that:
- use is made of several heat sources for simultaneously heating at a same melting temperature, a corresponding number of different locations equally spaced apart over at least one part of the length of said element;
- the element and the heat sources are moved with respect to each other in such a manner that each of said locations on said length of the element is subject to one and only one passage under one of said heat sources, said passage providing the requested melt-texturing simultaneously at said different locations on said length, said melt-texturing being provided at a same time, under a same temperature and same speed conditions and in a same direction so as to form a same number of similar zones of oriented microstructure along said at least one part of said given length of said element, said zones increasing in length until they merge;
- any other part of the length of said element is then subjected to the same treatment until all the length is formed of zones of oriented microstructure joined to each other; and
- prior to proceeding to said melt-texturing the spacing between the different locations where such melt-texturing is carried out, is adjusted as a function of the amount of impurities initially present in the precursor material to make it sure that the concentration of impurities which tend to increase along said zones of oriented microstructure while said zones are being formed along the element, always remain under a predetermined value where the requested superconductivity of the so-produced element is not dramatically reduced.

2. The method according to claim 1, characterized in that the melt-texturing is carried out by moving the element past said heat sources.

3. The method according to claim 2, characterized in that the element moves along a spiral path and thus forms a multi-whorl circular winding, and in that said heat sources are positioned along at least one line intersecting said whorls.

4. The method according to claim 3, characterized in that the spiral path is in a furnace heated at the temperature required to achieve the requested melt-texturing, and in that the heat sources are defined as holes provided in a thermal shield protecting the element moving along the spiral path within the furnace.

5. The method according to any one of claims 1 to 4, characterized in that the element is formed by inserting the grains of precursor material into a hollow tube made of a metal alloy permeable to oxygen and subsequently drawing said tube into a wire or ribbon.

6. The method according to any one of claims 1 to 4, characterized in that the element is formed by applying the grains of precursor material onto a support by plasma spraying or doctor blading.

7. The method according to any one of claims 1 to 6, characterized in that it further comprises sintering the grains of precursor material prior to subjecting the element to said direction texturing.

8. The method according to any one of claims 1 to 7, characterized in that:
- the precursor material consists of a powder of Y Ba₂Cu₃O_{7-δ} precursor; and
- the melt-texturing is carried out at a temperature ranging from 1000°C to 1100°C and is adjusted to have a temperature gradient ranging from 20 to 200°C per millimeter in the element so as to make it sure that al the impurities are property dissolved and moved along the zone of oriented microstructure while these zones are formed and increase in length.

## Patentansprüche

1. Verfahren zur Fertigung eines aus supraleitender Keramik mit hoher Übergangstemperatur hergestellten Teils einer gegebenen Länge der Art, die die nachfolgenden Schritte umfaßt:
- Bildung des Teils einer gegebenen Länge aus Prekursorkörnem der genannten supraleitenden Keramik mit hoher Übergangstemperatur, wobei sich diese Körner nebeneinander über die ganze Länge des genannten Teils erstrecken,
- richtungsmäßige Erstarrung durch Zonenschmelzen des genannten Teils, über die ganze Lange, bei ausreichender Temperatur und Geschwindigkeit, um die mikrostrukturelle Orientierung der Prekursorkörner zu ändern und also neue Körner zu erhalten, die ausgerichtet sind und eine gute Verbindung zwischen den Körnern haben, und
- Glühen unter Sauerstoff des also nach richtungsmäßiger Erstarrung erhaltenen Teils aus supraleitender Keramik, sodaß dessen Sauerstoffgehalt eingestellt und dessen Übergangstemperatur erhöht wird,
wobei das genannte Verfahren dadurch gekennzeichnet ist, daß
- mehrere Wärmequellen verwendet werden, die eine entsprechende Anzahl verschiedener, über wenigstens einen Teil der Länge des genannten Teils gleich voneinander beabstandeter Stellen gleichzeitig auf eine gleiche Schmelztemperatur erhitzen,
- der Teil und die Wärmequellen so zu einander verchoben werden, daß jede der genannten Stellen über die genannte Länge des Teils nur einer einzigen Durchfahrt unterhalb einer der genannten Wärmequellen unterworfen wird, wobei diese Durchfahrt gleichzeitig die erforderliche richtungsmäßige Erstarrung an den verschiedenen Stellen über die genannte Länge sichert und zwar zu einem gleichen Zeitpunkt, bei einer gleichen Temperatur, einer gleichen Geschwindigkeit und in einer gleichen Richtung, sodaß eine gleiche Anzahl ähnlicher Bereiche mit orientierter Mikrostruktur an dem genannten behandelten Teil des Teils entlang gebildet werden, wobei die genannten Bereiche an Länge zunehmen, bis sie miteinander verbunden sind,
- jeglicher anderer, noch nicht behandelter Teil der Länge des genannten Teils derselben Behandlung unterworfen wird, bis diese ganze Länge aus miteinander verbundener Bereiche mit orientierter Mikrostruktur gebildet ist, und
der Abstand zwischen den verschiedenen Stellen, an denen die genannte, gleichzeitige richtungsmäßige Erstarrung durchgeführt wird, bevor diese richtungsmäßige Erstarrung vorgenommen wird, je nach der Menge der anfänglich im Prekursor vorhandenen Verunreinigungen eingestellt wird, um sicherzustellen, daß die Konzentration der Verunreinigungen die dazu niegt entlang den Bereichen mit orientierter Struktur zuzunehmen während diese Bereiche an dem Teil entlang gebildet werden, stets unterhalb eines vorgegebenen Wertes bleibt, bei dem die erforderliche Supraleitfähigkeit des also gefertigten Teils nicht erheblich vermindert ist.

2. Verfahren nach Anspruch 1, dadurch gekennzeichnet, daß die richtungsmäßige Erstarrung durchgeführt wird, indem der Teil die genannten Wärmequellen entlang verschoben wird.

3. Verfahren nach Anspruch 2, dadurch gekennzeichnet, daß sich der Teil einen spiralförmigen Weg entlang verschiebt und also eine Schneckenwindung aus meheren Windungen bildet, und daß die Wärmequellen wenigstens eine Linie, die die gennanten Windungen schneidet entlang angeordnet sind.

4. Verfahren nach Anspruch 3, dadurch gekennzeichnet, daß sich der spiralförmige Weg in einem Ofen befindet, der auf die erforderliche Temperatur erhitzt wird, um die gewünschte richtungsmäßige Erstarrung zu gewährleisten, und daß die Wärmquellen aus Löchem bestehen, die in einer Wärmeschutzwand vorgesehen sind, die dazu dient, den sich den spiralförmige Weg innerhalb des Ofens entlang verschiebenden Teil zu schützen.

5. Verfahren nach einem der Ansprüche 1 bis 4, dadurch gekennzeichnet, daß der Teil dadurch gebildet wird, daß die Prekursorkörner in ein hohles Rohr aus einer sauerstoffdurchlässigen Metallegierung hineingeführt werden und das genannte Rohr anschließend zu einem Faden oder einem Band gezogen wird.

6. Verfahren nach einem der Ansprüche 1 bis 4, dadurch gekennzeichnet, daß der Teil dadurch gebildet wird, daß die Prekursorkörner durch Plasmazerstäubung oder durch Bestreichung auf einen Träger angebracht werden.

7. Verfahren nach einem der Ansprüche 1 bis 6, dadurch gekennzeichnet, daß es außerdem ein Sintern der Prekursorkörner, bevor der Teil der genannten richtungsmäßigen. Erstarrung unterworfen wird, umfaßt.

8. Verfahren nach einem der Ansprüche 1 bis 7, dadurch gekennzeichnet, daß:
- der Prekursor aus einem Y Ba₂Cu₃O_{7-δ}-Prekursorpulver besteht, und
- die richtungsmäßige Erstarrung bei einer Temperatur zwischen 1000 und 1100°C durchgeführt und so eingestellt wird, daß es einen Temperaturgradient zwischen 20 und 200° C pro Millimeter im Teil gibt, um also sicherzustellen, daß sämtliche Verunreinigungen gut gelöst sind und entlang den Bereichen mit orientierter Mikrostruktur verschoben werden, während sich diese letzten bilden und sie an Länge zunehmen.
